Europäisches Patentamt

European Patent Office

Office européen des brevets

(19)

(11) Publication number : **0 539 227 A1**

## (12) EUROPEAN PATENT APPLICATION

(21) Application number : **92309745.5**

(22) Date of filing : **23.10.92**

(51) Int. Cl.$^5$ : **G03F 7/075,** G03F 7/004, G03F 7/027

(30) Priority : **24.10.91 GB 9122576**

(43) Date of publication of application :
**28.04.93 Bulletin 93/17**

(84) Designated Contracting States :
**DE FR GB**

(71) Applicant : **HERCULES INCORPORATED**
**Hercules Plaza**
**Wilmington Delaware 19894-0001 (US)**

(72) Inventor : **Yokoyama, Wako**
**2611 Whittier Place/Heritage Park**
**Wilmington, Delaware 19808 (US)**

(74) Representative : **De Minvielle-Devaux, Ian**
**Benedict Peter et al**
**CARPMAELS & RANSFORD 43, Bloomsbury**
**Square**
**London WC1A 2RA (GB)**

(54) Reducing plugging in printing plates made from polymerizable compositions.

(57)    This invention is directed to an aqueous developable composition suitable for preparing printing plates, comprising (a) a polymerizable material and (b) a hydrophobic compound containing an element selected from the group consisting of fluorine, chlorine, and silicon, the hydrophobic compound being capable of copolymerizing with the polymerizable composition, wherein the aqueous developable composition is aqueous developable and curable, and wherein a printing plate made from the aqueous developable composition has a contact angle at least about 5% higher than the contact angle of the same printing plate made with the same composition without the hydrophobic compound. The invention is also directed to a printing plate comprising a substrate and the composition, including such a printing plate wherein the printing plate has been imagewise exposed and developed, and uncured composition has been removed, and a process of forming an image on a printing plate comprising imagewise exposing the printing plate, developing the plate, and postcuring the plate.

EP 0 539 227 A1

Jouve, 18, rue Saint-Denis, 75001 PARIS

Field of the Invention

The present invention relates to aqueous developable compositions useful for preparing printing plates, printing plates made from an aqueous developable composition, and processes of forming images using the same.

Background of the Invention

Aqueous developable curable compositions are well known in the manufacture of flexible printing plates. Generally, printing plates are made by imagewise exposing the curable compositions to a curing light through a negative to cure the composition in the exposed areas. The unexposed composition is then washed away with an aqueous solution (aqueous developed) leaving the cured portion as a relief image, which forms the printing surface of the printing plate.

One problem that can arise in the use of such printing plates is known as "plugging." Plugging is the phenomenon whereby, after a period of time on a printing machine, foreign material builds up on the surface of the printing plate, in particular between relief parts of the plate. The plugging material can be, for example, dried ink, a mixture of dried ink and paper dust or paper fiber, dust, or merely dirt. Plugging can often prevent a uniform transfer of ink from the printing plate to the printed substrate.

It is known to apply to the surface of printing plates a surfactant in order to reduce smudging, described as the buildup of ink in the depressions of the relief image, such as described in U.S. Pat. No. 4,478,885. Examples of such surfactants are fluorocarbon surface active agents having a perfluoroalkyl group with 4-14 carbon atoms. However, treating printing plates in this way is not ideal, since the surface active agents can wear off after time.

Furthermore, in any attempt to modify the compositional components of a printing plate, the delicate balance of properties that must be maintained has to be considered. The plate must be sufficiently hard to transfer an image to a substrate in a printing press, while at the same time being sufficiently flexible and resistant to cracking to last for a sufficient period of time. Any additive to the curable composition has a potential to adversely affect this delicate balance. Also, the curing characteristics of the composition must be considered, particularly in photo-curing. Photo-curable compositions are designed to effect an adequate cure in exposed areas and to effect development such that a clear definition between exposed and unexposed areas is maintained in order to effect a clear image. Any potential additive has the potential to interfere with the curing properties.

With the aforesaid considerations in mind, the present inventors developed a curable composition useful in making printing plates that is resistant to plugging and exhibits excellent printing qualities and good durability.

Summary of the Invention

Accordingly, this invention is directed to an aqueous developable composition suitable for preparing printing plates, comprising (a) a polymerizable material and (b) a hydrophobic compound containing an element selected from the group consisting of fluorine, chlorine, and silicon, the hydrophobic compound being capable of copolymerizing with the polymerizable composition, wherein the aqueous developable composition is aqueous developable and curable, and wherein a printing plate made from the aqueous developable composition has a contact angle at least about 5% higher than the contact angle of the same printing plate made with the same composition without the hydrophobic compound. The invention is also directed to a printing plate comprising a substrate and the composition, including such a printing plate wherein the printing plate has been imagewise exposed and developed, and uncured composition has been removed, and a process of forming an image on a printing plate comprising imagewise exposing the printing plate, developing the plate, and postcuring the plate.

Detailed Description of the Invention

The hydrophobic compound is a material having a surface energy less than water and is present in the composition of the present invention in an amount sufficient to reduce the hydrophilicity of the cured material made therefrom. At least one of the elements fluorine, chlorine, or silicon is present in the compound. The printing plate must remain sufficiently hydrophilic so as to retain water-based printing ink uniformly on its printing surface. Therefore, the amount and character of the hydrophobic compound used cannot be such that it would make the surface too hydrophobic, that is, prevent the plate from properly functioning by not allowing it to retain water-based ink uniformly on its printing surface. Preferably, the amount of hydrophobic compound used is from about 0.2% to about 5%, more preferably from about 0.5% to about 3%, by weight of the composition. It is also preferred that the amount of the hydrophobic compound used be such that the amount of at least one of the elements fluorine, chlorine, or silicon comprises at least about 0.05% by weight of the compound, more preferably from about 0.05 to about 2.5%. In addition to being capable of imparting the desired hydrophobicity to the cured material, the hydrophobic compound must also be capable of copolymerizing with the polymerizable material in the developable composition. For example, hydrophobic compounds having ethylenically unsaturated functional groups, in particular, compounds having at least two ethylenically unsaturated functional groups, such as acrylates and methacrylates, are useful in accordance with the present invention. The hydrophobic compound becomes part of the crosslinked matrix that comprises the cured printing plate. Exemplary hydrophobic compounds include silicones, silanes, siloxanes, and fluorinated materials. Specific examples are methacryloxyropyltris (trimethylsiloxy)silane, methacryloxypropylpentamethylsiloxane, siloxane polyacrylate, 2-(N-butylperfluorooctane-sulfonamido)ethylacrylate, and tetra chloro bisphenol a diacrylate.

In accordance with the present invention, the hydrophobic compound is added to polymerizable materials (also referred to as photopolymer resins or resin systems) useful in the manufacture of printing plates. Typical polymerizable materials useful in accordance with the present invention are well known, such as the polyurethane-based resin systems disclosed in U.S. Pat. Nos. 4,358,345, and 3,960,572. In addition to the aforesaid polyurethane systems, other useful resin systems include polyvinyl alcohol resin systems, polyester resin systems, and nylon resin systems. The resin systems can be of the type used either in liquid or paste form. Also, the composition of the present invention can be used as part of a two-part printing plate, wherein the composition forms the cap of the plate and another resin is used to form the base of the plate, or the composition can be used by itself.

In a preferred embodiment of the present invention, the polymerizable material comprises a polyurethane prepolymer (oligomer) and addition-polymerizable monomers in combination with a free-radical photoinitiator and a stabilizer. The prepolymer is incorporated in the polymerizable composition at an amount of from about 55% to about 98%, preferably from about 65% to about 80%, by weight of the composition. The addition-polymerizable monomer is present in an amount of from about 2% to about 45%, preferably from about 14% to about 34%, by weight of the composition. The free-radical photoinitiator is present in an amount of from about 0.01% to about 5%, preferably from about 0.5% to about 3%, by weight of the composition, and the stabilizer is present in an amount of from about 0.05% to about 2%, from about 0.1% to about 0.3%, by weight of the composition.

Examples of useful polyurethane prepolymers in accordance with the present invention are well known. Typically, such prepolymers are made by chain extending diols with toluene diisocyanate and end capping with hydroxymethacrylates. Exemplary polyurethane prepolymers are disclosed in the aforesaid U.S. Pat. Nos. 4,358,354 and 3,960,572. Preferably, the prepolymer has a molecular weight (number average) of 2000-30000, more preferably 15000-20000.

The addition-polymerizable monomer useful in accordance with the present invention is a compound containing at least 1, preferably at least 2, more preferably 2 to 4, most preferably 2 to 3 ethylenic double bonds, or a mixture of said compounds. Suitable addition-polymerizable monomers include alkylene or polyalkylene glycol diacrylates. Monomers containing vinylidene groups conjugated with ester linkages are particularly suitable. Illustrative examples include but are not limited to ethylene diacrylate; diethylene glycol diacrylate; glycerol diacrylate; glycerol triacrylate; 1,3-propanediol dimethacrylate; 1,2,4-butanetriol trimethacrylate; 1,4-benzenediol dimethacrylate; 1,4-cyclohexanediol diacrylate; pentaerythritol tri- and tetramethacrylate; pentaerythritol tri- and tetraacrylate; tetraethylene glycol dimethacrylate; trimethylolpropane trimethacrylate; triethylene glycol diacrylate; tetraethylene glycol diacrylate; pentaerythritol triacrylate; trimethylol propane triacrylate; pentaerythritol tetraacrylate; 1,3-propanediol diacrylate; 1,5-pentanediol dimethacrylate; and the bis-acrylates and bis-methacrylates of polyethylene glycols, polypropylene glycols, and copolymers thereof of molecular weight from about 100 to about 500 (number average). Other useful addition-polymerizable monomers will be apparent to those skilled in the art.

The free-radical photoinitiator useful in accordance with this invention is a conventional photoinitiator activatable by actinic radiation that is thermally inactive below about 185°C. For example, 1,1- or 2,2-dimethoxyphenylacetophenone, benzoin isobutyl ether, and other benzoin types are suitable photoinitiators. Examples of other useful photoinitiators are found in U.S. Pat. No. 4,268,610. Additional exemplary photoinitiators are aromatic ketones, such as benzophenone and dimethoxyphenyl acetophenone, Michler's ketone, 4,4'-bis(diethylamino)-benzophenone, tert-butylanthroquinone, 2-ethylanthraquinone, thiozanthones, benzoin alkyl ethers, and benzyl ketals. Other useful photoinitiators will be apparent to those skilled in the art. While photoinitiated polymerization is the preferred method of polymerization, alternative means of polymerization, such a thermal polymerization using thermal polymerization initiators, and electron beam irradiation, are also contemplated within the scope of the present invention. Techniques and materials for alternate means of polymerization will be readily apparent to one of ordinary skill in the art.

A stabilizer is added to a preferred composition of the present invention to prevent premature polymerization. Typical stabilizers are butylated hydroxytoluene and hydroquinone monomethylether. Other additives are also useful, for example, additives that impart a waxy surface to the finished plate or reduce tack, such as myristic acid, oleamide, and dimyristyl thiodipropionate.

Printing plates of this invention have conventional configurations and are made using equipment and techniques well-known to the person of ordinary skill in the art. The printing plates are imagewise exposed and aqueous developed, and then the uncured composition is removed. A postcure step is preferred. Printing plates made with the composition of this invention, containing the hydrophobic additive, provide higher contact angles than the corresponding compositions that do not contain the hydrophobic additive. The higher contact angles indicate lower surface energies and improved wettability. Printing plates made with the compositions of this invention have a contact angle at least about 5%, preferably at least about 10% and most preferably at least about 20%, greater than the same printing plates having the same compositions without the hydrophobic additive. Generally, at substitution levels of about 2%, the contact angle will be about 20% to about 50% higher than that of a printing plate having the same composition without the hydrophobic additive.

Plates made with the invention have good ink transfer. Plugging is reduced and the plates wash off more easily with water or dilute detergent solution than plates made with the same composition not having the hydrophobic composition.

In order to more clearly describe the present invention the following non-limiting examples are provided. All parts and percentages in the following examples are by weight unless indicated otherwise.

Examples 1-4

Hydrophobic compounds were added to various photopolymer resins to demonstrate anti-plugging effectiveness. The photopolymer resins were commercial resins specified in the following tables. The hydrophobic compound was a polysilicone polyacrylate available from Radcure, Louisville, Kentucky, under the name EBECRYL 350. After mixing well and degassing, printing plates were made of the control resins and the resins containing the hydrophobic compound using a Hercules Type 50 platemaker unit (available from Hercules Incorporated, Wilmington, DE) at exposure times of $T_1 = 30$ seconds and $T_2 = 60$ seconds. The resins were poured over glass slides so that a smooth surface was available for contact angle measurement.

Contact angles were measured for printing plates made form each of the photopolymers alone compared with each of the photopolymers containing 2 weight% of the hydrophobic compound. The contact angle of the plates was measured using Advent water-based black flexo ink BK9014 (available from Advent Ink, Lancaster, PA). The average contact angle and standard deviation were calculated. Results are shown below.

| Photopolymer | Additive | Angle | Deviation |
|---|---|---|---|
| EPD1468[1] | -- | 57.1 | 2.5 |
| EPD1468[1] | HYDR. CMPD.[3] | 75.9 | 5.3 |
| EPD1641[1] | -- | 59.0 | 2.7 |
| EPD1641[1] | HYDR. CMPD. | 78.6 | 1.8 |
| 135DLT[2] | -- | 54.6 | 2.1 |
| 135DLT[2] | HYDR. CMPD. | 76.6 | 2.3 |
| Flexo 135SP[2] | -- | 69.5 | 1.6 |
| Flexo 135SP[2] | HYDR. CMPD. | 89.1 | 1.6 |

[1] Available from Hercules Incorporated, Wilmington, DE.

[2] Available from W.R. Grace, Atlanta, Georgia.

[3] Hydrophobic compound.

The results show that plates made using the composition of this invention, containing the hydrophobic additive, afforded higher contact angles and, thus, lower surface energies, than the corresponding control resins.

## Claims

1. An aqueous developable composition suitable for preparing printing plates, comprising (a) a polymerizable material and (b) a hydrophobic compound containing an element selected from the group consisting of fluorine, chlorine, and silicon, the hydrophobic compound being capable of copolymerizing with the polymerizable composition, wherein the aqueous developable composition is aqueous developable and curable, and wherein a printing plate made from the aqueous developable composition has a contact angle at least about 5% higher than the contact angle of the same printing plate made with the same composition without the hydrophobic compound.

2. The composition of claim 1 wherein the hydrophobic compound has ethylenic functionality.

3. The composition of claim 1 wherein the hydrophobic compound has at least two ethylenically unsaturated functional groups.

4. The composition of any of the preceeding claims wherein the hydrophobic compound is selected from the group consisting of silicones, silanes, siloxanes and fluorinated materials.

5. The composition of claim 1 wherein the hydrophobic compound is selected from the group consisting of methacryloxypropyl-tris(trimethylsiloxy)silane, methacryloxypropylpentamethyl-siloxane, siloxane polyacrylate, and 2-(N-butylperfluorooctane-sulfonamido)ethylacrylate.

6. The composition of any of the preceeding claims wherein the amount of the hydrophobic compound is from about 0.2 to about 5% by weight of the composition.

7. The composition of claim 6 wherein the amount of the hydrophobic compound is from about 0.5 to about 3% by weight of the composition.

8. The composition of any of the preceeding claims wherein the polymerizable material is selected from the group consisting of polyurethane, polyvinyl alcohol, polyester and nylon resins.

9. The composition of claim 8 wherein the polymerizable material comprises a polyurethane prepolymer and an addition type monomer selected from the group consisting of alkylene or polyalkylene glycol diacrylates, and monomers containing vinylidene groups conjugated with ester linkages.

10. The composition of claim 8 wherein the polymerizable material comprises a polyurethane prepolymer and an addition type monomer selected from the group consisting of ethylene diacrylate; diethylene glycol diacrylate; glycerol diacrylate; glycerol triacrylate; 1,3-propanediol dimethacrylate; 1,2,4-butanetriol trimethacrylate; 1,4-benzenediol dimethacrylate; 1,4-cyclohexanediol diacrylate; pentaerythritol tri- and tetramethacrylate; pentaerythritol tri- and tetraacrylate; tetraethylene glycol dimethacrylate; trimethylolpropane trimethacrylate; triethylene glycol diacrylate; tetraethylene glycol diacrylate; pentaerythritol triacrylate; trimethylol propane triacrylate; pentaerythritol tetraacrylate; 1,3-propanediol diacrylate; 1,5-pentanediol dimethacrylate; and the bis-acrylates and bis-methacrylates of polyethylene glycols, polypropylene glycols, and copolymers thereof of number average molecular weight from about 100 to about 500.

11. The composition of any of the preceeding claims further comprising a free-radical photoinitiator.

12. The composition of any of the preceeding claims comprising the prepolymer in an amount of from about 55% to about 98%, the addition-polymerizable monomer in an amount of from about 2% to about 45%, the hydrophobic compound in amount of from about 0.2% to about 5%, free-radical photoinitiator in an amount of from about 0.01% to about 5%, and stabilizer in an amount of from about 0.05% to about 2%, by weight of the composition.

13. The composition of claim 12 comprising the prepolymer in an amount of from about 65% to about 80%, the addition-polymerizable monomer in an amount of from about 14% to about 34%, the hydrophobic compound in an amount of from about 0.5% to about 3%, free-radical photoinitiator in an amount of from about 0.5% to about 3%, and stabilizer in an amount of from about 0.1% to about 0.3%, by weight of the composition.

14. The composition of any of the preceeding claims wherein a printing plate made from the aqueous composition has a contact angle at least about 10% higher than the contact angle of the same printing plate made with the composition without the hydrophobic compound.

15. The composition of claim 14 wherein a printing plate made from the aqueous composition has a contact angle at least about 20% higher than the contact angle of the same printing plate made with the composition without the hydrophobic compound.

16. A printing plate comprising a substrate and the composition of any of the preceeding claims.

17. A printing plate as claimed in claim 16 wherein the printing plate has been imagewise exposed and developed, and uncured composition has been removed.

18. A process of forming an image on a printing plate comprising imagewise exposing the printing plate of claims 16 or 17, developing the plate, and postcuring the plate.

**European Patent Office**

# EUROPEAN SEARCH REPORT

Application Number

EP 92 30 9745

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | DATABASE WPIL<br>Week 9125,<br>Derwent Publications Ltd., London, GB;<br>AN 91-182376<br>& JP-A-3 111 409 (MITSUBISHI METAL KK) 13 May 1991<br>* abstract *<br>--- | 1-18 | G03F7/075<br>G03F7/004<br>G03F7/027 |
| Y | PATENT ABSTRACTS OF JAPAN<br>vol. 13, no. 303 (P-896)(3651) 12 July 1989<br>& JP-A-10 78 248 ( SHIN ETSU CHEM CO LTD ) 23 March 1989<br>* abstract *<br>--- | 1-18 | |
| A | EP-A-0 239 082 (FUJI PHOTO FILM)<br>* page 4, line 9 - line 12 *<br>* page 13, line 11 - line 13; claims *<br>--- | 1-18 | |
| A | US-A-4 693 958 (A.M. SCHWARTZ ET AL.)<br>* column 5, line 55 - line 65 *<br>* column 10, line 35 - line 40 *<br>----- | 1-18 | TECHNICAL FIELDS SEARCHED (Int. Cl.5)<br><br>G03F |

The present search report has been drawn up for all claims

| Place of search | Date of completion of the search | Examiner |
|---|---|---|
| THE HAGUE | 28 JANUARY 1993 | DUPART J-M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)